# EUROPÄISCHE PATENTANMELDUNG

(11) **EP 1 498 953 A2**
(43) Veröffentlichungstag der Anmeldung: **19.01.2005**
(21) Anmeldenummer: 04013795.2
(22) Anmeldetag: 11.06.2004
(51) Int. Cl.: H01L 27/115, H01L 21/8246

(54) **Halbleiterspeicher mit Ladungshaftstellen-Speicherzellen**

(30) Priorität: 15.07.2003 DE 10332095
(71) Anmelder: Infineon Technologies AG, 81669 München (DE); Infineon Technologies Flash GmbH & Co. KG., 01099 Dresden (DE)
(72) Erfinder: Willer, Josef, 85521 Riemerling (DE); Ludwig, Christoph, 01465 Langebrück (DE); Deppe, Joachim, 01099 Dresden (DE)
(74) Vertreter: Epping, Hermann, Fischer

(57) **Zusammenfassung**

In einer Charge-Trapping-Speicherarchitektur für Virtual Ground mit parallel zu den Wortleitungen (2) vorhandenen Querverbindungen (6) und parallel zu den Bitleitungen (4) vorhandenen STI-Isolationen (1) werden zur Einteilung in Slices verbreiterte STI-Isolationen (7) angebracht. Statt dessen können die unter einer Bitleitung vorhandenen Querverbindungen weggelassen sein oder zwei zueinander benachbarte Bitleitungen (41, 42) so beschaltet werden, dass die dazwischen vorhandenen Speichertransistoren nur im Leerbetrieb arbeiten.

## Beschreibung

Eine Speicherzelle weist einen Speichertransistor auf, der an einer Oberseite eines Halbleiterkörpers oder einer Halbleiterschicht mit einer Gate-Elektrode versehen ist, die zwischen einem Source-Bereich und einem Drain-Bereich angeordnet ist, die in dem Halbleitermaterial ausgebildet sind. Die Gate-Elektrode ist von dem Halbleitermaterial durch dielektrisches Material getrennt. Bei einer Charge-trapping-Speicherzelle, insbesondere einer SONOS-Zelle oder NROM-Zelle, ist zumindest zwischen dem Source-Bereich und der Gate-Elektrode und zwischen dem Drain-Bereich und der Gate-Elektrode eine Schichtfolge vorhanden, die eine für das Einfangen von Ladungsträgern an Source und Drain vorgesehene Speicherschicht zwischen Begrenzungsschichten umfasst. Das Material der Begrenzungsschichten besitzt eine höhere Energiebandlücke als das Material der Speicherschicht, so dass die Ladungsträger, die in der Speicherschicht zwischen den Begrenzungsschichten gefangen sind, dort lokalisiert bleiben.

Als Material für die Speicherschicht kommt vorzugsweise ein Nitrid in Frage; als umgebendes Material ist vorrangig ein Oxid geeignet. Bei einer Speicherzelle im Materialsystem von Silizium ist die Speicherzelle in diesem Beispiel Siliziumnitrid mit einer Energiebandlücke von etwa 5 eV, die umgebenden Begrenzungsschichten Siliziumoxid mit einer Energiebandlücke von etwa 9 eV. Die Speicherschicht kann ein anderes Material mit einer kleineren Energiebandlücke als derjenigen der Begrenzungsschichten sein, wobei die Differenz der Energiebandlücken für einen guten elektrischen Einschluss der Ladungsträger (confinement) möglichst groß sein soll. In Verbindung mit Siliziumoxid kann so z. B. Tantaloxid, Hafniumsilikat, Titanoxid (im Fall stöchiometrischer Zusammensetzung TiO₂), Zirkonoxid (im Fall stöchiometrischer Zusammensetzung ZrO₂), Aluminiumoxid (im Fall stöchiometrischer Zusammensetzung Al₂O₃) oder intrinsisch leitendes (undotiertes) Silizium als Material der Speicherschicht eingesetzt werden. Siliziumnitrid besitzt eine relative Dielektrizitätszahl von etwa 7,9. Die Verwendung eines alternativen Materials mit einer höheren Dielektrizitätszahl (z. B. ≈ 15 ... 18) gestattet eine Verringerung der oxidäquivalenten Gesamtdicke des für die Speicherung vorgesehenen Schichtstapels und ist daher von Vorteil.

In der deutschen Patentanmeldung Akz 10258194.0 ist ein Halbleiterspeicher mit Charge-trapping-Speicherzellen beschrieben, bei dem die Kanalbereiche jeweils quer zu der betreffenden Wortleitung verlaufen und die Bitleitungen auf der Oberseite der Wortleitungen und von diesen elektrisch isoliert angeordnet sind. In Zwischenräumen zwischen den Wortleitungen und davon elektrisch isoliert sind elektrisch leitende Querverbindungen (Interconnects) vorhanden, die abschnittsweise mit den Bitleitungen verbunden sind.

Gemäß einer fortlaufenden Nummerierung der Speichertransistoren längs einer jeweiligen Wortleitung verbinden diese Querverbindungen auf einer Seite der Wortleitung jeweils einen Source-/Drain-Bereich eines geradzahlig nummerierten Speichertransistors mit einem Source-/Drain-Bereich des in dieser Nummerierung folgenden, ungeradzahlig nummerierten Speichertransistors elektrisch leitend und auf der gegenüberliegenden Seite dieser Wortleitung jeweils einen Source-/Drain-Bereich eines ungeradzahlig nummerierten Speichertransistors mit einem Source-/Drain-Bereich des in dieser Nummerierung folgenden, geradzahlig nummerierten Speichertransistors. Die Wortleitungen können zwischen den Bitleitungen mit Wortleitungsstraps kontaktiert sein, die den elektrischen Bahnwiderstand verringern.

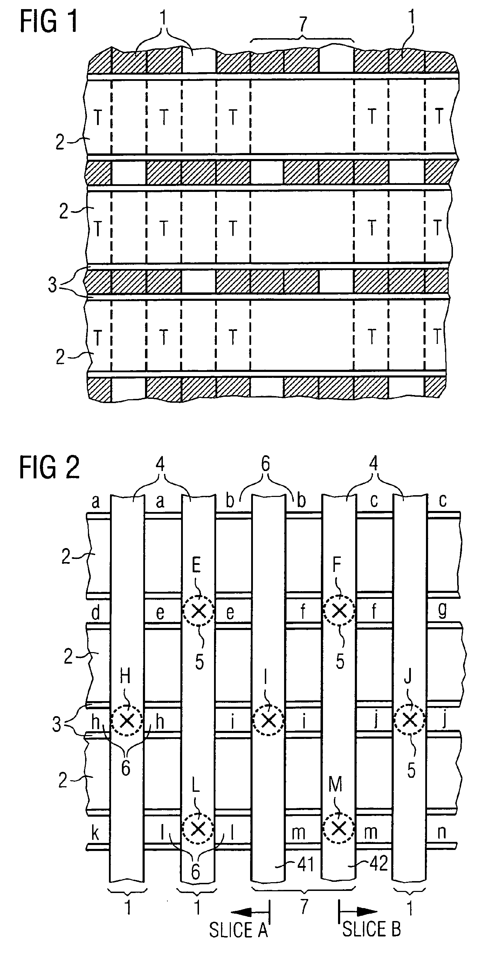

Die Figur 1 zeigt eine Draufsicht auf ein Schema, in dem die Positionen der STI-Isolationen 1, Wortleitungen 2 mit seitlichen Spacern 3 und der miteinander elektrisch leitend zu verbindenden Bereiche erkennbar sind. Die STI-Isolationen 1 (STI = shallow trench isolation) stellen eine Vielzahl von parallel im Abstand zueinander angeordneten Isolationsgräben dar, die vorzugsweise mit einem Oxid des Halbleitermaterials gefüllt sind. Es kann aber auch ein anderes Dielektrikum in den Isolationsgräben vorhanden sein. Die STI-Isolationen sind parallel im Abstand zueinander angeordnet. Dazwischen sind jeweils unter jeder Wortleitung 2 parallel zu den Isolationsgräben verlaufende Kanalbereiche der Speichertransistoren T vorhanden. Die Wortleitungen verlaufen daher über die quer zu der Längsrichtung der Wortleitung angeordneten Kanalbereiche.

Seitlich an die Wortleitungen angrenzend sind jeweils die Source-/Drain-Bereiche der Speichertransistoren T vorhanden. Diese Source-/Drain-Bereiche werden in den in der Figur 1 jeweils schraffiert gekennzeichneten Bereichen elektrisch leitend miteinander verbunden, wobei jeweils ein kurzes Stück des betreffenden Isolationsgrabens überbrückt wird.

In der Figur 2 ist eine Draufsicht auf diese Anordnung einschließlich der über den Wortleitungen aufgebrachten Bitleitungen 4 dargestellt. Die in der Figur 1 schraffiert eingezeichneten Bereiche sind mit elektrisch leitendem Material bedeckt, im Folgenden als Querverbindungen (Interconnects) bezeichnet, und in der Figur 2 jeweils mit denselben Kleinbuchstaben bezeichnet. Die Querverbindungen 6 werden von den Bitleitungen 4 kontaktiert. Die Bitleitungskontakte 5 sind in der Figur 2 als verborgene Konturen gestrichelt eingezeichnet und mit einem Kreuz gekennzeichnet. Die Bitleitungskontakte 5 sind ferner jeweils mit demjenigen Großbuchstaben bezeichnet, der dem Kleinbuchstaben der betreffenden Querverbindung 6 entspricht.

Es ist in der Figur 2 erkennbar, dass die Bitleitungen 4 jeweils an Querverbindungen 6 elektrisch kontaktiert sind, die in der Richtung der Bitleitungen aufeinanderfolgend jeweils in übernächsten Zwischenräumen zwischen den Wortleitungen 2 angeordnet sind. Die Querverbindungen 6 überbrücken jeweils eine STI-Isolation 1 und verbinden einen jeweiligen Source- / Drain-Bereich mit einem in dem betreffenden Zwischenraum zwischen den Wortleitungsstegen nachfolgenden Source-/Drain-Bereich. Sie sind voneinander elektrisch isoliert und daher abschnittsweise ausgebildet und voneinander durch dielektrisches Material getrennt.

Halbleiterspeicher werden in Abschnitte, so genannte Slices, unterteilt, die bei der hier beschriebenen Speicherarchitektur in der Regel 33 oder 34 aufeinander folgende Bitleitungen umfassen. Auf diese Weise sind Speicherareale gebildet, die typisch 33 × 256 oder 33 × 512 Speicherzellen umfassen. Die Slices müssen elektrisch voneinander getrennt werden und sind für ein gemeinsames Löschen der darin vorhandenen Speicherzellen vorgesehen.

Aufgabe der vorliegenden Erfindung ist es, einen Halbleiterspeicher mit Charge-trapping-Speicherzellen in Virtualground-Architektur der eingangs beschriebenen Art anzugeben, der in Slices aufgeteilt ist.

Diese Aufgabe wird mit dem Halbleiterspeicher mit den Merkmalen des Anspruches 1 gelöst. Ausgestaltungen ergeben sich aus den abhängigen Ansprüchen.

Zur Aufteilung des Halbleiterspeichers in Slices werden in vorgegebenen Abständen die periodisch angeordneten Reihen von Speichertransistoren T zwischen zwei aufeinanderfolgenden betreffenden Bitleitungen unterbrochen. Es sind dort entweder statt der Transistoren nur Isolationsbereiche vorhanden, oder die vorhandenen Transistoren werden nicht als Speicherzellen des Halbleiterspeichers verwendet.

Bei einer ersten Ausführungsform ist zwischen zwei aufeinander folgenden Bitleitungen in dem Halbleiterkörper oder Substrat statt einer Transistorstruktur eine Isolation vorhanden. Diese Isolation kann insbesondere den gesamten Bereich zwischen den angrenzenden STI-Isolationen isolieren. In diesem Fall bildet die Isolation zusammen mit den angrenzendenden STI-Isolationen eine einzelne breitere STI-Isolation.

Eine weitere Möglichkeit besteht darin, die Abfolge von Querverbindungen unter der betreffenden Bitleitung zu unterbrechen. Anstelle der Querverbindungen sind unter der betreffenden Bitleitung isolierende Bereiche vorhanden, die vorzugsweise dadurch ausgebildet sind, dass das zur Isolation der Querverbindungen untereinander vorgesehene dielektrische Material auch in diese isolierenden Bereiche eingebracht ist. Es können bei der betreffenden Bitleitung die Bitleitungskontakte weggelassen sein. Wenn die betreffenden Bitleitungskontakte fehlen und dadurch eine ausreichende elektrische Isolation der Bitleitung bewirkt ist, können unter der betreffenden Bitleitung die Querverbindungen gegebenenfalls vorhanden sein.

Eine Aufteilung des Halbleiterspeichers kann auch schaltungstechnisch vorgenommen sein. Die Struktur des Speicherzellenfeldes kann dann streng periodisch sein; die Grenzen zwischen den Slices ergeben sich nur aufgrund der Ansteuerung der Bitleitungen. Das geschieht in diesem Fall so, dass eine Reihe von Speichertransistoren zwischen den beiden betreffenden Bitleitungen als Dummy-Speicherzellen, im Folgenden als Leerbetrieb-Speicherzellen bezeichnet, beschaltet sind.

Es folgt eine genauere Beschreibung von Beispielen des Halbleiterspeichers anhand der beigefügten Figuren 1 bis 4.

Die Figur 1 zeigt ein Anordnungsschema der STI-Isolationen und Wortleitungen.

Die Figur 2 zeigt ein Anordnungsschema der Wortleitungen, Bitleitungen und Querverbindungen sowie der Unterteilung in Slices für ein erstes Ausführungsbeispiel.

Die Figur 3 zeigt ein Anordnungsschema der Wortleitungen, Bitleitungen und Querverbindungen sowie der Unterteilung in Slices für ein zweites Ausführungsbeispiel.

Die Figur 4 zeigt ein Anordnungsschema der Wortleitungen, Bitleitungen und Querverbindungen sowie der Unterteilung in Slices für ein drittes Ausführungsbeispiel.

In der Figur 1 ist eine Schnittaufsicht auf ein Anordnungsschema der STI-Isolationen und Wortleitungen bei einem ersten Ausführungsbeispiel dargestellt, bei dem in der Abfolge von parallel zueinander angeordneten STI-Isolationen 1 eine breitere STI-Isolation 7 vorhanden ist. Dort ist also die in gleichem Abstand vorhandene Anordnung von Speichertransistoren T unterbrochen. Die Bitleitungen 4 können gemäß der Figur 2 auf der Oberseite dieser Struktur in gleichmäßigen Abständen angeordnet sein. Die betreffenden Bitleitungen 41, 42 dienen dann zur Ansteuerung der Speichertransistoren in Slice A (Bitleitung 41) bzw. der Speichertransistoren in Slice B (Bitleitung 42). Zwischen diesen Bitleitungen 41, 42 sind keine Transistoren vorhanden. Die breitere STI-Isolation 7 bildet eine Grenze zwischen den Slices A, B.

Um bei der Herstellung zu erreichen, dass die aktiven Bereiche zwischen den STI-Isolationen auf einem dem gesamten Speicher zugrunde liegenden gleichmäßigen Raster angeordnet sind, also die Periodizität in der Aufeinanderfolge der aktiven Bereiche über die Grenzen der Slices hinweg konstant bleibt und dort nur einmal unterbrochen ist, können die jeweils an die breitere STI-Isolation 7 angrenzenden aktiven Bereiche etwas breiter ausgebildet sein als die übrigen aktiven Bereiche. Die aktiven Bereiche können aber auch alle dieselbe Breite besitzen, wenn bei der Herstellung eventuell auftretende Proximity-Effekte durch die Ausgestaltung der Maske, die zur Strukturierung der STI-Isolationen verwendet wird, geeignet ausgeglichen werden.

Das geschieht vorzugsweise mittels an sich bekannter Assist-Linien in der Maske. Die Maske besitzt im Bereich der vorgesehenen STI-Isolationen Öffnungen, die an den Grenzen der Slices entsprechend den dort vorgesehenen breiteren STI-Isolationen breiter sind als über den übrigen STI-Bereichen. Längs der Mitte der breiteren Öffnungen werden jeweils schmale Anteile der Maske vorgesehen, so genannte Assist-Linien, die ausreichend schmal sind, um bei der nachfolgenden Lithographie keine Abschirmung im Bereich der breiteren STI-Isolationen zu bewirken, aber für eine Belichtung der angrenzenden Bereiche in dem vorgesehenen Raster sorgen.

Das beschriebene Ausführungsbeispiel hat den Vorteil, dass die Einteilung des Halbleiterspeichers in Slices, die gegeneinander elektrisch isoliert sind, mit vergleichsweise geringem Aufwand durchgeführt werden kann, ohne dass die strenge Periodizität der Anordnung der aktiven Bereiche wesentlich beeinträchtigt wird. Folglich ist die Verteilung der Schwellenspannungen der Speichertransistoren im Vergleich zu dem nicht in Slices unterteilten Speicher im Wesentlichen gleich.

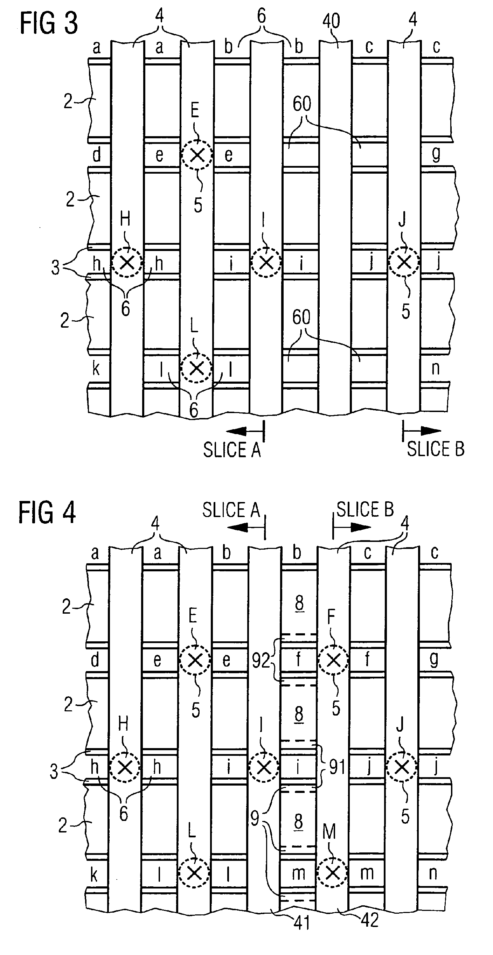

Bei dem Ausführungsbeispiel gemäß der Figur 3 sind unter einer betreffenden Bitleitung 40 die Querverbindungen 6 weggelassen. Anstelle der Querverbindungen sind nur isolierte Bereiche 60 vorhanden. Die isolierten Bereiche 60 können vorzugsweise dadurch ausgebildet sein, dass das dielektrische Material, das zur elektrischen Isolierung der Querverbindungen untereinander in die Zwischenräume zwischen den Wortleitungen 2 eingebracht wird, auch unter der betreffenden Bitleitung 40 eingebracht wird. Diese Bitleitung 40 sollte vorzugsweise auf Masse (ground) gelegt werden. Die Anschlusskontakte der betreffenden Bitleitung 40 sind vorzugsweise weggelassen. Falls das für eine elektrische Isolation ausreicht, können eventuell die Querverbindungen unter dieser betreffenden Bitleitung 40 vorhanden sein und nur die Anschlusskontakte der Bitleitung auf den Querverbindungen weggelassen sein.

Bevorzugt ist jedoch das Ausführungsbeispiel, bei dem die betreffenden Querverbindungen weggelassen sind.

Dieses Ausführungsbeispiel hat den Vorteil, dass die Periodizität der mit den Transistorstrukturen versehenen aktiven Bereiche nicht unterbrochen wird. Die Verteilung der Schwellenspannungen der Speichertransistoren ist bei diesem Ausführungsbeispiel am schmalsten.

Bei dem Ausführungsbeispiel gemäß der Figur 4 ist die Struktur des Halbleiterspeichers gegenüber der eingangs beschriebenen Struktur unverändert. Eine Einteilung des Halbleiterspeichers in elektrisch voneinander getrennte Slices erfolgt ausschließlich durch die Beschaltung. Abgesehen von dem Rand ist die Speicherzellenanordnung bei diesem Ausführungsbeispiel periodisch. Zwischen zwei betreffenden Bitleitungen 41, 42 auf der Grenze zwischen Slice A und Slice B befindet sich eine Reihe von Speichertransistoren, die nicht als solche zum Abspeichern von Informationen verwendet werden. Statt dessen bilden diese Speichertransistoren Dummy-Transistoren oder Leerbetrieb-Speicherzellen 8. Bei den Charge-Trapping-Speicherzellen können durch geeignete Polung der an den Bitleitungen anliegenden Spannungen Bits an beiden Kanalenden gespeichert werden. Die Speicherplätze 9 sind in der Figur 4 durch die gestrichelten Linien an den beiden Enden der Transistorstrukturen angrenzend an die Source-/Drain-Bereiche dargestellt.

Die Programmierung erfolgt durch Einfangen heißer Ladungsträger aus dem Kanal in der Speicherschicht zwischen der Gate-Elektrode, die Bestandteil der jeweiligen Wortleitung ist, und dem Halbleitermaterial des Kanals. Vor dem ersten Löschen eines Slices und jeweils zwischen den weiteren Löschvorgängen wird in den Speicherplätzen 9 der an das zu löschende Slice angrenzenden Leerbetrieb-Speicherzellen jeweils ein Bit programmiert, um einen so genannten Over-Erase zu verhindern. Es werden dabei jeweils diejenigen Speicherplätze der Leerbetrieb-Speicherzellen 8 programmiert, deren jeweils benachbarter Source-/Drain-Bereich über eine Querverbindung 6 mit einem Source-/Drain-Bereich in dem zu löschenden Slice elektrisch leitend verbunden ist.

Falls bei dem in der Figur 4 dargestellten Beispiel Slice A gelöscht werden soll, werden also vor dem Löschen die Speicherplätze 91 programmiert, da diese Speicherplätze benachbart zu einem Source-/Drain-Bereich sind, der über die eingezeichnete Querverbindung i mit einem weiteren Source-/Drain-Bereich innerhalb Slice A verbunden ist. Entsprechend werden vor dem Löschen von Slice B die Speicherplätze 92 programmiert, da diese Speicherplätze benachbart zu einem Source-/ Drain-Bereich sind, der über die eingezeichnete Querverbin/ dung f mit einem weiteren Source-/Drain-Bereich innerhalb Slice B verbunden ist. Während dieser Programmierung wird die an das zu löschende Slice angrenzende äußere Bitleitung des benachbarten Slice, beim Löschen von Slice A also die Bitleitung 42 und beim Löschen von Slice B die Bitleitung 41, auf 0 Volt (Masse) gelegt.

Bei dem anschließenden Löschvorgang werden die in den Leerbetrieb-Speicherzellen 8 eingeschriebenen Bits mitgelöscht. Es ist vorteilhaft, wenn die Speicherplätze der Leerbetrieb-Speicherzellen 8 direkt anschließend an den Löschvorgang wieder programmiert werden, um eventuell auftretende Leckströme zu minimieren und Probleme beim Auslesen der randseitig in Slice A bzw. Slice B angeordneten Speichertransistoren zu vermeiden. Das Programmieren wird vorzugsweise so vorgenommen, dass sich die Schwellenspannung stark erhöht und die Leckströme durch den Transistor sehr klein werden.

Die Vorteile dieses Ausführungsbeispiels sind ein geringer Platzverbrauch ohne Unterbrechung der Periodizität der aktiven Bereiche, der Querverbindungen und der Bitleitungskontakte und eine sehr schmale Schwankung in der Verteilung der Schwellenspannungen der Speichertransistoren.

Bezugszeichenliste
- 1: STI-Isolation
- 2: Wortleitung
- 3: Spacer
- 4: Bitleitung
- 40: spezielle Bitleitung
- 41: spezielle Bitleitung
- 42: spezielle Bitleitung
- 5: Bitleitungskontakt
- 6: Querverbindung
- 60: isolierter Bereich
- 7: breitere STI-Isolation
- 8: Leerbetrieb-Speicherzelle
- 9: Speicherplatz
- a: Querverbindung
- b: Querverbindung
- c: Querverbindung

- n: Querverbindung
- E: Bitleitungskontakt
- F: Bitleitungskontakt

- M: Bitleitungskontakt
- T: Speichertransistor

## Patentansprüche

1. Halbleiterspeicher mit Charge-trapping-Speicherzellen, bei dem ein Halbleiterkörper oder Substrat vorhanden ist, in dem Speichertransistoren (T) ausgebildet sind, die jeweils einen Kanalbereich zwischen Source-/Drain-Bereichen, eine Gate-Elektrode und eine dielektrische Speicherschichtfolge zwischen der Gate-Elektrode und dem Kanalbereich aufweisen, STI-Isolationen (1) in dem Halbleiterkörper oder Substrat vorhanden sind, die im Abstand zueinander in einer von Source nach Drain verlaufenden Längsrichtung der Kanalbereiche zwischen den Speichertransistoren (T) angeordnet sind, Bitleitungen (4) vorhanden sind, die längs der STI-Isolationen (1) angeordnet sind, Wortleitungen (2) vorhanden sind, die zeilenweise quer zu den Bitleitungen (4) verlaufend und von den Bitleitungen (4) elektrisch isoliert im Abstand zueinander angeordnet sind, wobei die Gate-Elektroden jeweils durch einen Abschnitt einer betreffenden Wortleitung (2) gebildet sind, die jeweilige Längsrichtung eines Kanalbereiches quer zu der betreffenden Wortleitung (2) verläuft, die Bitleitungen (4) über einer von dem Halbleiterkörper oder Substrat abgewandten Oberseite der Wortleitungen (2) angeordnet sind, elektrisch leitende Querverbindungen (6) vorhanden sind, die abschnittsweise in Zwischenräumen zwischen den Wortleitungen (2) und davon elektrisch isoliert angeordnet sind, die Querverbindungen (6) gemäß einer fortlaufenden Nummerierung der Speichertransistoren (T) längs einer jeweiligen Wortleitung (2)
a) auf einer Seite der Wortleitung (2) jeweils einen Source- / Drain-Bereich eines geradzahlig nummerierten Speichertransistors (T) mit einem Source-/Drain-Bereich des in dieser Nummerierung folgenden, ungeradzahlig nummerierten Speichertransistors (T) elektrisch leitend verbinden und
b) auf der gegenüberliegenden Seite dieser Wortleitung (2) jeweils einen Source-/Drain-Bereich eines ungeradzahlig nummerierten Speichertransistors (T) mit einem Source-/Drain-Bereich des in dieser Nummerierung folgenden, geradzahlig nummerierten Speichertransistors (T) elektrisch leitend verbinden und die Bitleitungen (4) jeweils an Querverbindungen (6) elektrisch kontaktiert sind, die in der Richtung der Bitleitungen (4) aufeinanderfolgend jeweils in übernächsten Zwischenräumen zwischen den Wortleitungen (2) angeordnet sind,
**dadurch gekennzeichnet, dass** zur Aufteilung des Halbleiterspeichers in Slices (A, B) in vorgegebenen Abständen jeweils längs einer betreffenden Bitleitung (40) oder jeweils zwischen zwei aufeinander folgenden betreffenden Bitleitungen (41, 42)
a) eine elektrische Isolation zwischen zwei aufeinander folgenden STI-Isolationen (1) zwischen den betreffenden Bitleitungen (41, 42) vorhanden ist oder
b) eine Unterbrechung der längs der Wortleitungen (2) vorhandenen Abfolge von Querverbindungen (6) unter der betreffenden Bitleitung (40) und/oder eine elektrische Isolation der betreffenden Bitleitung (40) von den Querverbindungen (6) vorhanden ist oder
c) eine Beschaltung der Bitleitungen (4) in der Weise vorgesehen ist, dass zwischen zwei aufeinander folgenden betreffenden Bitleitungen (41, 42) eine Reihe von Speichertransistoren (T) zur elektrischen Trennung der beidseitig dieser Reihe vorhandenen Speichertransistoren (T) eingesetzt wird.

2. Halbleiterspeicher nach Anspruch 1, bei dem eine elektrische Isolation zwischen zwei aufeinander folgenden STI-Isolationen (1) unter zwei aufeinander folgenden Bitleitungen (41, 42) dadurch bewirkt ist, dass die betreffenden STI-Isolationen und ein dazwischen vorhandener Bereich zusammen als eine breitere STI-Isolation (7) ausgebildet sind.

3. Halbleiterspeicher nach Anspruch 1, bei dem eine Unterbrechung der längs der Wortleitungen (2) vorhandenen Abfolge von Querverbindungen (6) unter einer Bitleitung (40) dadurch bewirkt ist, dass im Bereich dieser Bitleitung (40) anstelle der Querverbindungen elektrisch isolierte Bereiche (60) vorhanden sind.

4. Halbleiterspeicher nach Anspruch 1, bei dem eine elektrische Isolation einer Bitleitung (40) von den Querverbindungen (6) dadurch bewirkt ist, dass diese Bitleitung (40) ohne Kontakte zu den Querverbindungen (6) ausgebildet ist.

5. Halbleiterspeicher nach Anspruch 1, bei dem eine Beschaltung der Bitleitungen (4) in der Weise vorgesehen ist, dass zwischen zwei aufeinander folgenden Bitleitungen (41, 42) eine Reihe von Speichertransistoren als Leerbetrieb-Speicherzellen (8) vorgesehen wird, die Leerbetrieb-Speicherzellen (8) über jeweils einen Speicherplatz (9) an zwei jeweils einem dem betreffenden Speicherplatz (9) benachbarten Source-/Drain-Bereich zugewandten Enden des Kanalbereiches verfügen und zumindest vor jedem Löschen eines der durch diese Reihe getrennten Slices (A, B) mittels der betreffenden Bitleitungen (41, 42) diejenigen Speicherplätze (91, 92) der Leerbetrieb-Speicherzellen (8) programmiert werden, deren jeweils benachbarter Source-/Drain-Bereich über eine Querverbindung (6) mit einem Source-/Drain-Bereich in dem zu löschenden Slice elektrisch leitend verbunden ist.

6. Halbleiterspeicher nach Anspruch 5, bei dem die Speicherplätze (9) der Leerbetrieb-Speicherzellen (8) bereits anschließend an jedes Löschen eines der angrenzenden Slices (A, B) programmiert werden.
